(19) Europäisches Patentamt
European Patent Office
Office européen des brevets

(11) **EP 4 462 146 A1**

(12) **EUROPEAN PATENT APPLICATION**

(43) Date of publication:
**13.11.2024  Bulletin 2024/46**

(21) Application number: **23172863.5**

(22) Date of filing: **11.05.2023**

(51) International Patent Classification (IPC):
**G01R 33/48** (2006.01)     G01R 33/56 (2006.01)
G01R 33/563 (2006.01)     G01R 33/567 (2006.01)

(52) Cooperative Patent Classification (CPC):
**G01R 33/4828;** G01R 33/5602; G01R 33/5607;
G01R 33/5608; G01R 33/5635; G01R 33/56366;
G01R 33/5676

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Siemens Healthineers AG**
**91301 Forchheim (DE)**

(72) Inventors:
- **Giese, Daniel**
  **91052 Erlangen (DE)**
- **Nickel, Marcel Dominik**
  **91074 Herzogenaurach (DE)**
- **Schmidt, Michaela**
  **91080 Uttenreuth (DE)**

(74) Representative: **Siemens Healthineers**
**Patent Attorneys**
**Postfach 22 16 34**
**80506 München (DE)**

(54) **COMPUTER-IMPLEMENTED METHOD FOR DETERMINING A MAGNETIC RESONANCE IMAGE DATA SET, MAGNETIC RESONANCE IMAGING DEVICE, COMPUTER PROGRAM AND ELECTRONICALLY READABLE STORAGE MEDIUM**

(57)    Computer-implemented method for determining a magnetic resonance image data set of an acquisition region comprising two proton species having a different spin characteristic, wherein, in the magnetic resonance image data set, contributions of one of the proton species are emphasized, the method comprising the steps of
- acquiring magnetic resonance signals from the acquisition region using an opposed-phase condition of the spins of the two proton species in a magnetic resonance imaging device (1), the magnetic resonance signals forming a raw data set,
- applying phase unwrapping of the background phase to the raw data set to determine an intermediate data set such that the intermediate data represents a difference between the contributions of one proton species and the contributions of the other proton species for each voxel, and
- determining the magnetic resonance image data set from the intermediate data set.

FIG 1

## Description

The invention concerns a computer-implemented method for determining a magnetic resonance image data set of an acquisition region comprising two proton species having a different spin characteristic, wherein, in the magnetic resonance image data set, contributions of one of the proton species are emphasized. The invention further concerns a magnetic resonance imaging device, a computer program and an electronically readable storage medium.

In magnetic resonance imaging, spins of protons bound differently may have slightly different magnetic resonance frequencies (Larmor frequencies), which may result in different phase evolution characteristics. The most well-known example for such proton species of protons bound in different molecules are water protons (protons bound in water molecules) and fat protons (protons bound in fat molecules). Since, in particular in patients as objects to be imaged, different fat molecules exist, the latter proton species (fat protons) is usually defined by using average values or otherwise statistically determined values.

On the other hand, in many applications, the desire to be able to separate contributions from fat and water (or other proton species) in magnetic resonance images exists. Here, the different spin characteristics, particular the different magnetic resonance frequencies, can be exploited. Two main approaches exist, namely separation techniques trying to mathematically determine water images only showing contributions from water protons and/or fat images only showing contributions from fat protons and suppression techniques trying to suppress the magnetic resonance signal from one of the proton species.

Regarding separation techniques, the Dixon technique is often applied. The basic idea of the Dixon technique is to acquire two magnetic resonance raw data sets, namely an in-phase image (same-phase image) and an out-of-phase image (opposed-phase image), and to determine a fat image and a water image by combining these raw data sets. This is also called two-point Dixon, and multiple variations have been proposed, in particular also three-point Dixon techniques. In magnetic resonance angiography (MRA), such Dixon techniques promise to increase contrast by robustly suppressing fat adjacent to vessels, but are time consuming, see, for example, L. Pennig et al., "Comparison of a novel Compressed SENSE accelerated 3D modified relaxation-enhanced angiography without contrast and triggering with CE-MRA in imaging of the thoracic aorta", Int J Cardiovasc Imaging 37, 315-329 (2021). Due to the multiple required raw data sets, this disadvantage also applies to other applications.

Some one-point Dixon approaches have also been proposed as variations of the Dixon technique. Focusing on water-fat-separation, these approaches rely on additional input or model assumptions. Furthermore, the echo time ideally corresponds to a perpendicular magnetization direction between water and fat components, usually relying on an image wherein the relative phase between the fat spins and the water spins is 90° or 270°. Hence, these techniques need additional information and have shown to be less robust than desired. Exemplarily, it is referred to Jingfei Ma, "A single-point Dixon technique for fat-suppressed fast 3D gradient-echo imaging with a flexible echo time", J. Magn Reson Imaging 27, 881-890 (2008), and Eric G. Stinson et al., "Time-resolved contrast-enhanced MR angiography with single-echo Dixon fat suppression", Magn Reson Med 80, 1556-1567 (2018).

Regarding techniques aiming to suppress the magnetic resonance signal of one proton species already before the readout, saturation techniques are known as well as spectral approaches only acting on the spins of one proton species. A well-known example is the so-called SPAIR technique (SPectral Attenuated Invention Recovery). While these methods are faster than multi-point Dixon approaches, they are less robust.

It is an object of the current invention to provide a method for fast and robust determination of magnetic resonance images emphasizing contributions of one proton species.

This object is achieved by providing a computer-implemented method, a magnetic resonance imaging device, a computer program and an electronically readable storage medium according to the independent claims. Advantageous embodiments are described by the dependent claims.

A method as initially described comprises, according to the invention, the following steps:

- acquiring magnetic resonance signals from the acquisition region using an opposed-phase condition of the spins of the two proton species in a magnetic resonance imaging device, the magnetic resonance signals forming a raw data set,
- applying phase unwrapping of the background phase to the raw data set to determine an intermediate data set such that the intermediate data represents a difference between the contributions of one proton species and the contributions of the other proton species for each voxel, and
- determining the magnetic resonance image data set from the intermediate data set.

The invention proposes a new approach to achieve a robust, self-contained, and fast technique relying on an antiparallel magnetization direction between the spins of the proton species. While, strictly speaking, no longer a separation of contributions from the different proton species is performed, it may still be understood as a one-point Dixon technique. While the method aims at applications that focus on water and/or fat dominated voxels such as magnetic resonance angiography, it can, of course, also be applied to other fields and other proton species.

In short, the invention requires the acquisition of only one raw data set, namely an opposed-phase image, when the relative phase between the spins of the two proton species is at least essentially 180°. After phase unwrapping, a clearly defined difference between the contributions of the proton species is provided. For example in the case of fat protons and water protons, where W denotes contributions of the water protons and F denotes contributions of the fat protons, the result may be a W - F image as intermediate image data set. Phase unwrapping allows to distinguish between W - F and F - W signals.

Generally speaking, phase unwrapping refers to correction of the effects of the background phase, which may, for example, be introduced by locally varying homogeneity of the main magnetic field. It relies on a smooth behavior of the background phase in space. Any known phase unwrapping method suitable for magnetic resonance imaging may be applied, for example methods based on seed growing and/or branch cut approaches. Also advance methods using trained functions, for example neural networks and/or machine learning, can be employed. Methods used for two-point Dixon approaches may preferably be used, wherein in the current invention, no in-phase raw data set is acquired, only the opposed-phase raw data set.

Regarding, for example, the separation of the contributions of water protons and fat protons, the Dixon method relies on the assumption that the signal at a voxel x and echo time Te can be modelled as

$$S_e(\mathbf{x}) = (W(\mathbf{x}) + c_e F(\mathbf{x})) e^{i\Phi_e(\mathbf{x})} \qquad (1)$$

with water proton contribution W($\mathbf{x}$), fat proton contribution F($\mathbf{x}$), dephasing coefficient $c_e$ and background phase error $\Phi e(\mathbf{x})$. Crucial ingredient is a robust determination of the phase error $\Phi e(\mathbf{x})$, which for previous one-point Dixon approaches relies on additional acquisitions or model assumptions, as detailed in the articles cited above by Ma and Stinson et al. Aiming at a robust, time-efficient approach without dependence on additional input, no additional penalty in the noise propagation and to suppress fat or water proton contribution in the resulting magnetic resonance image, the known approach is modified. According to the invention, focus is put on opposed-phase echo times for which $c_e$ = -1 (or, in general, real and negative). Existing phase unwrapping methods as, for example, used for two-point Dixon can then be used to determine the background phase error $\Phi e(\mathbf{x})$, and a phase-corrected intermediate data set having the contrast W($\mathbf{x}$) - F($\mathbf{x}$) can be obtained. Due to the subtraction of fat proton contributions, the intermediate data set already focuses on water-dominated voxels, that is, water proton contributions are emphasized. The intermediate data set hence suffices for determining the magnetic resonance image data set; no other data sets are required. In some embodiments, hence, the intermediate data set can be directly used as the magnetic resonance image data set.

However, in preferred embodiments and generally speaking, the magnetic resonance image data set may be determined by, for each voxel, determining the maximum of the respective intermediate data value and a threshold. For example, the threshold may be zero. In this manner, more focus is laid on voxels dominated by the proton species of interest. In the example discussed above, a water image may be obtained as magnetic resonance image data set by

$$WmF(\mathbf{x}) = \max(W(\mathbf{x}) - F(\mathbf{x}), 0). \qquad (2)$$

Such a magnetic resonance image data set only shows water dominated image voxels and therefore efficiently emphasizes water and suppresses fat, albeit with a modified contrast for voxels that contain both components (compared to known separation techniques). It is noted that a corresponding image focusing on fat-dominated voxels may simply be determined by using the inverse intermediate data set, F($\mathbf{x}$) - W($\mathbf{x}$) (or determining a minimum and inverting afterwards).

Generally speaking, due to its time efficiency, the method according to the invention is especially advantageous regarding patients with irregular breathing patterns. Here, the acceleration of scan time the proposed method offers is crucial. However, generally advantageously, the method according to the invention can be applied without any required breath holds and may thus be free-breathing technique. Here, breathing motion can be compensated in the raw data set by known means. For example, during acquisition of the raw data set, a breathing state of the free-breathing patient may be measured and the measurement data may be used to compensate breathing motion in the raw data set. Preferably, the breathing state may be measured using a diaphragmatic navigator sequence by the magnetic resonance imaging device. For example, a cross-paired navigator may be used, in particular measuring along two different directions. A range of the navigator may, for example, be +/- 4.5 mm.

Experiments also showed a higher robustness compared to the pure application of proton species suppression techniques. For example, SPAIR fat suppression in the thorax may have problems to completely suppress the mediastinal adipose fat. Here, the method according to the invention provides better results. Consistency with slower, multi-point Dixon approaches was shown.

In summary, according to the invention, a one-point Dixon approach for MRI based on opposed-phase imaging is presented, which allows to suppress fat dominated voxels effectively while maintaining scan time efficiency. The method according to the invention allows large fields of view, free breathing and high resolution. While being as fast as simple suppression strategies, one proton species may be robustly suppressed and a high signal for voxels dominated by the proton species of interest and contrast to surrounding materials is maintained.

In preferred embodiments, the magnetic resonance signals are acquired after applying suppression of one of the proton species, in particular the one whose contributions are not to be emphasized in the magnetic resonance image data set. That is, the inventive one-point approach may advantageously also be combined with at least one suppression technique. Suppression may, for example, be applied by using certain radio frequency pulses acting only onto the spins of the proton species to be suppressed, for example by choosing an output time such that a defined phase relationship exists or by spectrally shaping the radio frequency pulse. In particular, a spectral attenuated inversion recovery (SPAIR) technique may be used for suppression. By combining a suppression technique and the one-point Dixon approach of the invention, quality and robustness of the resulting images are further improved, in particular by suppressing contributions remaining even after applying suppression techniques without decreasing time efficiency.

The approach described here may be used for native acquisitions, for example native magnetic resonance angiography. However, it can also be applied if a contrast agent is present in the acquisition region. Since, usually, fat does not absorb contrast agent, fat suppression may not be required in such a case.

As already mentioned above, the main application of the method according to the invention may be fat and/or water suppression. That is, the proton species may be fat protons, which are bound in fat molecules, and water protons, which are bound in water molecules.

An advantageous application is MRA. For example, magnetic resonance angiography may be performed, wherein contributions from water protons are emphasized in the magnetic resonance image. In angiography, blood vessels are imaged, wherein blood usually comprises no fat. Hence, water proton contributions may be emphasized and fat suppressed. In MRA, it is especially preferable to keep scan times short. In particular when the acquisition region comprises the heart or is close to the heart, the acquisition of the raw data set may be ECG-triggered. Since the T2 relaxation time is long for blood, preferably, a T2-prepared acquisition may be performed. Preferably, free breathing may be allowed due to the one-point nature of the approach.

However, besides native MRA, the method according to the invention may also be advantageously applied in other situations. For example, when acquiring the magnetic resonance signals, perfusion imaging and/or time-of-flight imaging may be applied.

In particularly advantageous embodiments, two magnetic resonance image data sets are determined sequentially and subtracted to determine at least one result data set. Since the two magnetic resonance image data sets are acquired at different time points, removal of fat background (or water background) cannot be guaranteed if movement occurred in the acquisition region. In the state of the art, this may lead to so-called fat edges from misaligned magnetic resonance image data sets of different time points. If the method according to the invention is applied in such a case, fat can be suppressed and fat edges can be omitted or at least reduced. Typical applications, in which such subtractions are performed and where the inventive approach is applied with particular advantage, comprise contrast-enhanced MRA, breast imaging, and other types of perfusion imaging.

In time-of-flight imaging, opposed-phase echo times are often used anyways, simplifying use of the approach of the current invention. In many TOF applications, for example in head examinations and/or when using the bright blood effect, maximum intensity projections (MIPs) are generated to visualize blood vessels. If fat contributions are suppressed by using the one-point approach described here, background signal in the MIPs can be reduced.

Also regarding these exemplary further applications, the invention can be advantageously applied without relevant increase in examination time.

Generally speaking, the magnetic resonance signals may preferably be acquired using gradient echo sequence (GRE sequence). However, other types of magnetic resonance sequences, for example spin echo sequences, may also be used.

The invention further concerns a magnetic resonance imaging device, comprising a control device, wherein the control device comprises:

- an acquisition unit for controlling the magnetic resonance imaging device to acquire magnetic resonance signals from an acquisition region, the acquisition region comprising two proton species having a different spin characteristic, using an opposed-phase condition of the spins of the two proton species, wherein the magnetic resonance signals form a raw data set,
- a phase unwrapping unit for applying phase unwrapping of the background phase to the raw data set to determine an intermediate data set such that the intermediate data represents a difference between the contributions of one proton species and the contributions of the other proton species for each voxel, and
- a determination unit for determining a magnetic resonance image data set from the intermediate data set, wherein, in the magnetic resonance image data set, contributions of one of the proton species are emphasized.

In other words, the control device is configured to perform a method according to the invention. All features and remarks regarding the method according to the invention may analogously be applied to the magnetic resonance imaging device according to the invention, such that the same advantages are achieved.

The control device may comprise at least one processor and at least one storage means and may be adapted to control operation of the magnetic resonance imaging device. The control device comprises the acquisition unit, which may be configured to generally control further components of the magnetic resonance imaging device to perform magnetic resonance imaging. In particular, it may be configured to implement at least one chosen magnetic resonance sequence. Regarding the current invention, it controls the magnetic resonance imaging device to acquire the raw data set, wherein, in particular, an echo time is chosen such that the opposed-phase condition of the spins of the two proton species is realized. In a phase unwrapping unit, phase unwrapping is applied to determine the intermediate data set. In a determination unit, the magnetic resonance image dataset is determined, for example by applying the threshold as discussed above.

A computer program according to the invention comprises program means, which, when the computer program is executed by a control device of a magnetic resonance imaging device, cause the control device to carry out the steps of a method according to the invention. The computer program may be stored on an electronically readable storage medium according to the invention, which thus comprises control information comprising a computer program according to the invention, such that, when the electronically readable storage medium is used in a control device of a magnetic resonance imaging device, the steps of a method according to the invention are performed.

Other objects and features of the present invention will become apparent from the following detailed description considered in conjunction with the accompanying drawings. The drawings, however, are only principle sketches designed solely for the purpose of illustration and do not limit the invention. The drawings show:

Fig. 1    a flowchart of an embodiment of a method according to the invention,

Fig. 2    an embodiment of a magnetic resonance imaging de-vice according to the invention, and

Fig. 3    the functional structure of a control device of the magnetic resonance imaging device.

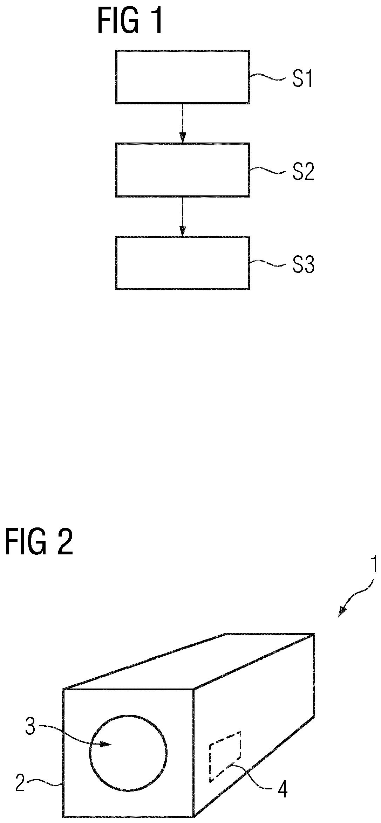

Figure 1 shows an embodiment of a method according to the invention, exemplarily applied in native MRA of a patient. The blood vessels, which are to be depicted, mainly comprise a first proton species, namely protons bound in water molecules (water protons). In the acquisition region of the patient, of course, also protons bound in fat molecules (fat protons) are found as second proton species. Of interest in MRA are the blood vessels, hence the water protons. On the other hand, in MRA, time is of the essence, such that the method discussed here only uses a measurement at one echo time to determine magnetic resonance images emphasizing water proton contribution.

In a step S1, a raw data set is acquired using a certain, single echo time, at which a relative phase between the spins of the fat protons and the spins of the water protons is 90° (opposed phase condition). That is, the raw data set is an opposed-phase image. A three-dimensional GRE magnetic resonance sequence with T2 preparation is used. The acquisition region may, for example, comprise the thorax and/or the upper abdomen. Preferably, ECG-triggering is applied. Since, on the other hand, only one raw data set at a certain echo time is acquired and required for determining the magnetic resonance image data set in later steps, no breath-hold is necessary. Free breathing of the patient is admitted and the breathing state may be measured using a cross-paired diaphragmatic navigator, which may have an acceptance window of +/- 4.5 mm.

In preferred embodiments, fat suppression may be additionally applied to further improve the emphasis on water, if water content is relevant, as is the case for MRA. Preferably, a SPAIR technique is used. Acceleration techniques, such as compressed sensing, may be applied to shorten acquisition time.

In step S2, phase unwrapping is applied to the raw data set, resulting in an intermediate data set having a contrast corresponding to the difference between water proton contributions and fat proton contributions. In this case, as already discussed above, $W(x) - F(x)$ is the intensity (intermediate data value) at each voxel $x$. Any suitable phase unwrapping approach may be used, in particular those already known for application in two-point Dixon techniques, where an opposed-phase image is acquired in addition to an in-phase image. The latter is not required here, so that a one-point Dixon technique is described.

In step S3, the magnetic resonance image data set is determined from only the intermediate data set, still corresponding to an opposed-phase image. While the intermediate data set, due to subtraction of the fat proton contribution, already emphasizes water-dominated voxels and could be used as the magnetic resonance image data set, preferably, to put further emphasis on water-dominated voxels, the magnetic resonance image data value for each voxel is determined as the maximum of the intermediate data value and a threshold. In particular, formula (2) as laid out above may be used.

As an additional magnetic resonance image data set, if fat suppression has not been applied, an image wherein fat proton contributions are emphasized may be determined in step S3 by inverting the intermediate data set (to F($\mathbf{x}$) - W($\mathbf{x}$)) and proceeding as laid out above for water dominated voxels. It is also possible to determine the minimum of the intermediate data value and a threshold and subsequently invert the result.

However, combining fat suppression and the one-point technique described here, namely using only an opposed-phase image to derive water proton contribution-emphasizing magnetic resonance images, advantageously leads to magnetic resonance image data sets akin to water images resulting from separation techniques, since F($\mathbf{x}$) are very low values or even vanish, at least locally.

In other embodiments, multiple magnetic resonance image data sets, each corresponding to a different time point, may be determined and result data sets may be derived by subtracting pairs of such magnetic resonance image data sets. For example, this may be advantageous if a contrast agent is used, preventing so-called fat edges. Another application is TOF imaging, where the fat suppression achieved in steps S1 to S3 may lead to reduction of background signal in MIPs.

Figure 2 shows an embodiment of a magnetic resonance imaging device 1 according to the invention. The magnetic resonance imaging device 1 comprises, as in principle known, a main magnet unit 2, which comprises the superconducting main magnet (not shown) and defines a cylindrical bore 3, into which a patient can be introduced for examination using a patient table (not shown). Also not shown for simplicity are a gradient coil arrangement and a radio frequency coil arrangement surrounding the bore 3.

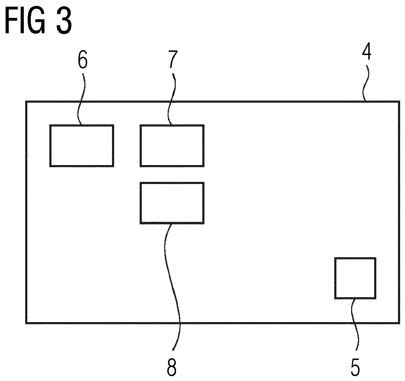

The operation of the magnetic resonance imaging device 1 is controlled by a control device 4. The functional structure of the control device 4 is further shown in Figure 3.

The control device 4 comprises a storage means 5 for storing information, such as acquisition parameters and data sets. An acquisition unit 6 controls acquisition of magnetic resonance signals, in particular also of the raw data set in step S1, by correspondingly operating further components of the magnetic resonance imaging device 1, like the gradient coil arrangement and the radio frequency coil arrangement or further transmit/receive means, like local coils.

In a phase unwrapping unit 7, phase unwrapping according to step S2 is performed to yield the intermediate data set. In a determination unit 8, the magnetic resonance image data set is determined according to step S3.

It is noted that, generally, the control device 4 may comprise further functional units, which may also be implemented in hardware and/or software, to implement optional steps, for example a breathing motion correction unit and/or an ECG triggering unit (coupled to an ECG measuring means of the magnetic resonance imaging device 1) and/or a subtraction unit to determine result data sets and/or an MIP unit to determine MIPs.

Although the present invention has been described in detail with reference to the preferred embodiment, the present invention is not limited by the disclosed examples from which the skilled person is able to derive other variations without departing from the scope of the invention.

Independent of the grammatical term usage, individuals with male, female or other gender identities are included within the term.

**Claims**

1. Computer-implemented method for determining a magnetic resonance image data set of an acquisition region comprising two proton species having a different spin characteristic, wherein, in the magnetic resonance image data set, contributions of one of the proton species are emphasized, the method comprising the steps of

   - acquiring magnetic resonance signals from the acquisition region using an opposed-phase condition of the spins of the two proton species in a magnetic resonance imaging device (1), the magnetic resonance signals forming a raw data set,
   - applying phase unwrapping of the background phase to the raw data set to determine an intermediate data set such that the intermediate data represents a difference between the contributions of one proton species and the contributions of the other proton species for each voxel, and
   - determining the magnetic resonance image data set from the intermediate data set.

2. Method according to claim 1, **characterized in that** the magnetic resonance image data set is determined by, for each voxel, determining the maximum of the intermediate data value and a threshold.

3. Method according to one of the preceding claims, **characterized in that** the threshold is zero.

4. Method according to one of the preceding claims, **characterized in that** the magnetic resonance signals are acquired after applying suppression of one of the proton species, in particular the one whose contributions are not to be emphasized in the magnetic resonance image data set.

5. Method according to claim 4, **characterized in that** a spectral attenuated inversion recovery technique is used for suppression.

6. Method according to one of the preceding claims, **characterized in that** the proton species are fat protons, which are bound in fat molecules, and water protons, which are bound in water molecules.

7. Method according to claim 6, **characterized in that** a magnetic resonance angiography is performed, wherein contributions from water protons are emphasized in the magnetic resonance image.

8. Method according to claim 6 or 7, **characterized in that** two magnetic resonance image data sets are determined sequentially and subtracted to determine at least one result data set.

9. Method according to one of the preceding claims, **characterized in that**, when acquiring the magnetic resonance signals, perfusion imaging and/or time-of-flight imaging is applied.

10. Method according to claim 9, **characterized in that** at least one maximum intensity projection is determined as the magnetic resonance image data set.

11. Method according to one of the preceding claims, **characterized in that**, during acquisition of the raw data set, a breathing state of the free-breathing patient is measured and the measurement data used to compensate breathing motion in the raw data set.

12. Method according to claim 11, **characterized in that** the breathing state is measured using a diaphragmatic navigator sequence by the magnetic resonance imaging device (1).

13. Magnetic resonance imaging device (1), comprising a control device (4), wherein the control device (4) comprises:

   - an acquisition unit (6) for controlling the magnetic resonance imaging device (1) to acquire magnetic resonance signals from an acquisition region, the acquisition region comprising two proton species having a different spin characteristic, using an opposed-phase condition of the spins of the two proton species, wherein the magnetic resonance signals form a raw data set,
   - a phase unwrapping unit (7) for applying phase unwrapping of the background phase to the raw data set to determine an intermediate data set such that the intermediate data represents a difference between the contributions of one proton species and the contributions of the other proton species for each voxel, and
   - a determination unit (8) for determining a magnetic resonance image data set from the intermediate data set, wherein, in the magnetic resonance image data set, contributions of one of the proton species are emphasized.

14. Computer program comprising program means, which, when the computer program is executed by a control device (4) of a magnetic resonance imaging device (1), cause the control device (4) to carry out the steps of a method according to one of the claims 1 to 12.

15. Electronically readable storage medium, whereon a computer program according to claim 14 is stored.

FIG 1

FIG 2

FIG 3

EP 4 462 146 A1

| | Europäisches Patentamt European Patent Office Office européen des brevets | **EUROPEAN SEARCH REPORT** | Application Number EP 23 17 2863 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 263 228 B1 (ZHANG WEIGUO [US] ET AL) 17 July 2001 (2001-07-17) | 1,6-15 | INV. G01R33/48 |
| Y | * column 6, line 66 - column 10, line 3; | 4-12 | |
| A | figure 3 * | 2,3 | ADD. G01R33/56 |
| | ----- | | G01R33/563 |
| Y | LÜSEBRINK FALK ET AL: "Comprehensive ultrahigh resolution whole brain in vivo MRI dataset as a human phantom", SCIENTIFIC DATA, vol. 8, no. 1, 25 May 2021 (2021-05-25), pages 1-13, XP093091642, DOI: 10.1038/s41597-021-00923-w * the whole document * | 6,7,9-11 | G01R33/567 |
| | ----- | | |
| Y | NEZAFAT MARYAM ET AL: "Coronary MR angiography at 3T: fat suppression versus water-fat separation", MAGNETIC RESONANCE MATERIALS IN PHYSICS, BIOLOGY AND MEDICINE, SPRINGER, DE, GB, vol. 29, no. 5, 2 April 2016 (2016-04-02), pages 733-738, XP036061800, ISSN: 0968-5243, DOI: 10.1007/S10334-016-0550-7 [retrieved on 2016-04-02] * the whole document * | 4-7,11, 12 | |
| | ----- | | TECHNICAL FIELDS SEARCHED (IPC) |
| Y | STINSON ERIC G. ET AL: "Time-resolved contrast-enhanced MR angiography with single-echo Dixon fat suppression", MAGNETIC RESONANCE IN MEDICINE, vol. 80, no. 4, 27 February 2018 (2018-02-27), pages 1556-1567, XP093091670, US ISSN: 0740-3194, DOI: 10.1002/mrm.27152 * figure 1 * | 6-10 | G01R |
| | ----- | | |

The present search report has been drawn up for all claims

| Place of search | Date of completion of the search | Examiner |
|---|---|---|
| Munich | 19 October 2023 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 17 2863**

This annex lists the patent family members relating to the patent documents cited in the above-mentioned European search report.
The members are as contained in the European Patent Office EDP file on
The European Patent Office is in no way liable for these particulars which are merely given for the purpose of information.

**19-10-2023**

| Patent document cited in search report | | Publication date | Patent family member(s) | | Publication date |
|---|---|---|---|---|---|
| US 6263228 | B1 | 17-07-2001 | JP | 4657405 B2 | 23-03-2011 |
| | | | JP | 2000070239 A | 07-03-2000 |
| | | | US | 6263228 B1 | 17-07-2001 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L. PENNIG et al.** Comparison of a novel Compressed SENSE accelerated 3D modified relaxation-enhanced angiography without contrast and triggering with CE-MRA in imaging of the thoracic aorta. *Int J Cardiovasc Imaging,* 2021, vol. 37, 315-329

- **JINGFEI MA.** A single-point Dixon technique for fat-suppressed fast 3D gradient-echo imaging with a flexible echo time. *J. Magn Reson Imaging,* 2008, vol. 27, 881-890
- **ERIC G. STINSON et al.** Time-resolved contrast-enhanced MR angiography with single-echo Dixon fat suppression. *Magn Reson Med,* 2018, vol. 80, 1556-1567